# FASCICULE DE BREVET EUROPEEN

(11) **EP 1 776 815 B1**
(45) Date de publication et mention de la délivrance du brevet: **01.10.2008**
(21) Numéro de dépôt: 05777725.2
(22) Date de dépôt: 11.08.2005
(51) Int. Cl.: H04L 25/49, H03M 7/14

(54) **CODEUR ET DECODEUR 9 BITS-10 BITS**
9-BIT-ZU-10-BIT-KODIERER UND -DEKODIERER
9-BIT TO 10-BIT ENCODER AND DECODER

(30) Priorité: 13.08.2004 FR 0408881
(43) Date de publication de la demande: 25.04.2007
(73) Titulaire: THALES, 92200 Neuilly sur Seine (FR)
(72) Inventeur: SONTAG, Yves, F-33200 Bordeaux (FR); GUFFROY, Michael, F-33200 Bordeaux (FR)
(74) Mandataire: Bréda, Jean-Marc
(86) Numéro de dépôt international: PCT/EP2005/053965
(87) Numéro de publication internationale: WO 2006/032583

(56) Documents cités:
- SLOMINSKI M M ET AL: "New 7B8B code for optical transmission" PROCEEDINGS OF THE 6TH MEDITERRANEAN ELECTROTECHNICAL CONFERENCE, 1991, SLOVENIA, vol. 1, 22 mai 1991 (1991-05-22), pages 618-620, XP010039971 ISBN: 0-87942-655-1

## Description

Le domaine de l'invention est celui des transmissions en série de données numériques. Ces données numériques sont notamment de type vidéo.

Il existe actuellement des familles de composants numériques très bien adaptés à la transmission série de données numériques composées de mots codés sur 10 bits. Ces composants sont fabriqués, par exemple par les sociétés NATIONAL SEMICONDUCTOR, MAXIM ou TEXAS. Ces composants sont généralement peu coûteux, peu volumineux et consomment peu. La transmission est le plus souvent assurée en ajoutant 2 bits complémentaires à chaque mot de 10 bits, le premier étant à un et le second à zéro. L'ajout des deux bits augmente légèrement la bande passante nécessaire à la transmission mais présente des avantages certains. On citera notamment :
- le bornage de la longueur maximale du mot sans transitions, les deux bits additionnels étant complémentaires et générant ainsi une transition systématique.
- La récupération des frontières du mot dans le flux des données série par le contrôle de la répétitivité permanente de la transition donnée par les 2 bits complémentaires.

Le support de cette transmission série peut être soit un câble électrique soit une fibre optique.

Excepté la condition de synchronisation de la liaison, le contenu des dix bits de chaque mot est laissé au libre choix de l'utilisateur, les composants numériques dédiés à la transmission ne comportant pas de dispositif de codage/décodage des données. Par conséquent, le nombre de zéros ou de uns de chaque mot n'est pas contrôlé et peut varier entre 0 et 10. Le signal peut donc comporter des mots comportant un grand nombre de uns ou de zéros successifs. Cela ne pose pas de problèmes lorsque la liaison transmet le continu. A titre d'exemple, on citera les liaisons de courte longueur en environnement favorable ou les liaisons de type « fond de panier » situées à l'intérieur de coffrets électroniques et qui relient les différentes cartes électroniques entre elles.

Cependant, dans certains types de transmission, les liaisons mises en oeuvre ne peuvent passer le continu. C'est le cas notamment des liaisons dites « AC coupled » utilisées en aéronautique pour le transfert de signaux vidéo entre calculateurs. Dans ce cas, si le mot numérique transmis comporte un grand nombre de uns ou de zéros successifs, la transmission peut être altérée. Par conséquent, il devient indispensable de transmettre des mots binaires comportant si possible des quantités voisines de zéros et de uns. Plus précisément, pour un mot de 10 bits, il est important que le nombre de uns ou de zéros soit compris entre 4 et 6.

Pour résoudre ce problème, il existe actuellement différents types de codage.

Une première solution consiste à utiliser un codage par bloc. Les codages standard sont soit des codages dits « 4B-5B » ou « 8B-10B ». Ainsi des mots de 4 bits sont transformés en mots de 5 bits et des mots de 8 bits sont transformés en mots de 10 bits. L'inconvénient de ces codes est que le nombre de bits utiles dans un mot codé sur 10 bits est réduit à 8. Ainsi, pour transmettre un signal vidéo standard comprenant trois signaux primaires composés de mots de 6 bits, soit une transmission de 18 bits au total, il est nécessaire d'utiliser 3 liaisons série transmettant chacune des mots de 10 bits alors qu'en principe, deux liaisons transmettant chacune des mots de 10 bits suffiraient, permettant ainsi de réduire de façon significative le nombre de câbles, la complexité et le coût de l'électronique nécessaire à la transmission.

Une seconde solution consiste à brouiller de façon pseudo-aléatoire le mot de données. En terminologie anglo-saxonne, on appelle cette opération « scrambler ». Par exemple, on peut utiliser le codage « 10B-10B » défini par la norme vidéo SMPTE 259, acronyme anglo-saxon de « Society of Motion Picture and Television Engineers ». Cette solution présente l'avantage de ne pas gaspiller de bits. Ce pendant, cette solution présente l'inconvénient que certaines séquences de mots génèrent des « patterns pathologiques » qui bloquent le brouillage et qui peuvent conduire à des cas transitoires où les mots ont une valeur moyenne en quantités de uns ou de zéros incompatibles de la bande passante des transformateurs de couplage.

Le document de Slominski et al., « new 7B8B code for optical transmission » proceedings of the 6th mediterraneen electrotechnical conference, 1991, Slovenia, vol.1, 22 mai 1991, pages 618-620 décrit un code 7B8B avec disparité limitée à zéro ou un. Les mots source de poids quasi-équilibrés (3 ou 4) sont codés par concaténation d'un bit d'équilibrage. Les autres mots source sont codés par d'autres règles plus compliquées. Ce principe a l'avantage de permettre un codage très simple pour tous les mots quasi-équilibrés. Cependant, ces règles de codage ne sauraient s'appliquer simplement au cas du codage de mots de 9 bits en mots de 10 bits.

Le codage et le décodage selon l'invention permettent de résoudre les inconvénients précédents au prix d'une augmentation du nombre de bits minimale. En effet, le dispositif décrit est un codeur de type « 9B-10B » permettant de coder un signal initial composé de mots de 9 bits en un signal composé de mots de 10 bits de façon à pouvoir le transmettre sans altérations au moyens de liaisons ne passant pas le continu. Bien entendu, le décodeur « 9B-10B » associé permet de réaliser la fonction inverse. Il décode un signal reçu composé de mots de 10 bits en un signal composé de mots de 9 bits permettant de retrouver le signal d'origine.

Ainsi, il est possible de coder ou de décoder un signal vidéo comportant 3 signaux de mots de 6 bits en 2 signaux de mots de 10 bits, réduisant le nombre de liaisons nécessaires à la transmission du signal vidéo à deux.

Plus précisément, l'invention a pour objet un codeur d'un mot binaire de 9 bits en un mot binaire de 10 bits, ledit codeur comportant des moyens de codage, caractérisé en ce que lesdits moyens effectuent au moins les codages suivants :
- Le codage d'un mot binaire de 9 bits comportant 3 uns ou 4 uns est obtenu en ajoutant un un audit mot de 9 bits pour obtenir un mot de 10 bits codé ;
- Le codage d'un mot binaire de 9 bits comportant 5 uns ou 6 uns est obtenu en ajoutant un zéro audit mot de 9 bits pour obtenir un mot de 10 bits codé.

Avantageusement, les moyens de codage effectuent les codages suivants :
- Le codage d'un mot binaire de 9 bits comportant moins de 3 uns est un mot binaire de 10 bits comportant 4 uns et commençant par un zéro.
- Le codage d'un mot binaire de 9 bits comportant plus de 6 uns est un mot binaire de 10 bits comportant 6 uns et commençant par un un.

Avantageusement, le codage d'un mot binaire de 9 bits comportant 2 uns est un mot binaire de 10 bits comportant 4 uns, débutant par un zéro, les 9 bits restant étant élaborés à partir du mot de 9 bits d'origine, en remplaçant 2 zéros conjoints dudit mot par deux uns de telle sorte que les 36 mots possibles de 9 bits comportant 2 uns aient tous un codage différencié.

Egalement, le codage d'un mot binaire de 9 bits comportant un un est un mot binaire de 10 bits comportant 4 uns, débutant par un zéro et comportant une séquence de 4 bits constituée de quatre uns successifs, la dite séquence pouvant être en deux parties, une première partie située à la fin du mot de 10 bits et la seconde partie située au début du mot de 10 bits après le premier zéro, de telle sorte que les 9 mots possibles de 9 bits comportant un un aient tous un codage différencié.

Avantageusement, le codage d'un mot binaire de 9 bits comportant 2 zéros est un mot binaire de 10 bits comportant 4 zéros débutant par un un, les 9 bits restant étant élaborés à partir du mot de 9 bits d'origine, en remplaçant 2 uns conjoints dudit mot par deux zéros de telle sorte que les 36 mots possibles de 9 bits comportant 2 zéros aient tous un codage différencié.

Avantageusement, le codage d'un mot binaire de 9 bits comportant un zéro est un mot binaire de 10 bits comportant 4 zéros, débutant par un un et comportant une séquence de 4 bits constituée de quatre zéros successifs, la dite séquence pouvant être en deux parties, une première partie située à la fin du mot de 10 bits et la seconde partie située au début du mot de 10 bits après le premier un, de telle sorte que les 9 mots possibles de 9 bits comportant un zéro aient tous un codage différencié.

L'invention concerne également un décodeur d'un mot binaire de 10 bits en un mot binaire de 9 bits, ledit décodeur comportant des moyens de décodage, caractérisé en ce que lesdits moyens effectuent les décodages uniquement sur les mots de 10 bits comportant ou 4 uns ou 5 uns ou 6 uns.

Avantageusement, les moyens de décodage effectuent au moins les décodage suivants :
- Le décodage d'un mot binaire de 10 bits comportant 5 uns est obtenu en supprimant le premier bit audit mot de 10 bits pour obtenir un mot de 9 bits décodé ;
- Le décodage d'un mot binaire de 10 bits comportant 4 uns et dont le premier bit est un un est obtenu en supprimant le premier bit audit mot de 10 bits pour obtenir un mot de 9 bits décodé ;
- Le décodage d'un mot binaire de 10 bits comportant 6 uns et dont le premier bit est un zéro est obtenu en supprimant le premier bit audit mot de 10 bits pour obtenir un mot de 9 bits décodé.

Avantageusement, les moyens de décodage effectuent les décodages suivants :
- Le décodage d'un mot binaire de 10 bits comportant 4 uns et dont le premier bit est un zéro est obtenu en supprimant le premier bit et en changeant au moins deux uns en zéros pour obtenir un mot de 9 bits comprenant au plus 2 uns.

Egalement, les moyens de décodage effectuent les décodages suivants :
- Le décodage d'un mot binaire de 10 bits comportant 6 uns et dont le premier bit est un un est obtenu en supprimant le premier bit et en changeant au moins deux zéros en uns pour obtenir un mot de 9 bits comprenant au moins 7 uns.

Avantageusement, un codeur ou un décodeur selon l'invention est intégré à un composant numérique programmable, notamment de type FPGA (Fast Programmable Gate Array) ou de type ASIC (Application Specific Integrated Circuit) pour applications à l'émission ou à la réception d'un signal vidéo numérique composé de mots de 10 bits.

L'invention sera mieux comprise et d'autres avantages apparaîtront à la lecture de la description qui va suivre donnée à titre non limitatif et grâce aux figures annexées parmi lesquelles :
- la figure 1 représente les tableaux de répartition du nombre de uns dans les mots de 9 bits et de 10 bits ;
- la figure 2 représente la correspondance de codage/décodage selon l'invention entre les mots de 9 bits et les mots de 10 bits associés ;
- les figures 3 à 11 représentent pour un exemple de mot de 9 bits comportant un nombre de uns variant de 0 à 9 le codage dans le mot de 10 bits associé ;
- les figures 12 et 13 représentent deux tableaux comportant 8 paires de colonnes, chaque paire de colonne donnant en hexadécimal le codage et le décodage d'un mot de 9 bits en un mot de 10 bits pour les mots de 9 bits compris entre 000 et 1FF;
- les figures 14 et 15 représentent les schémas électriques de principe du codeur et du décodeur selon l'invention.

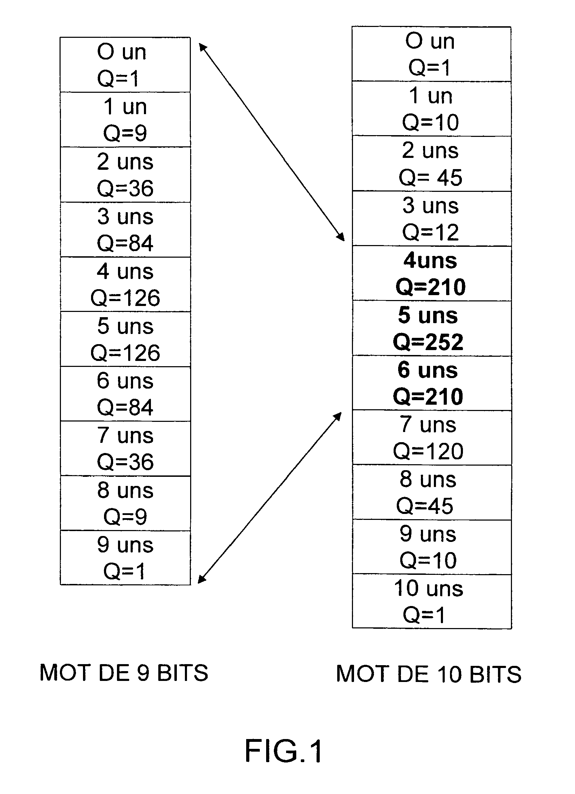

Il existe 2⁹ mots de 9 bits différents, soit 512 au total et il existe 2¹⁰ mots de 10 bits différents, soit 1024 au total. Les tableaux de la figure 1 représentent la répartition de la quantité Q de uns dans les mots de 9 bits et de 10 bits. Comme il a été dit, il est essentiel, pour sécuriser la liaison, que les mots de 10 bits comportent un nombre équilibré de uns et de zéros. Or, le second tableau de la figure 1 montre qu'il existe au total 672 mots de 10 bits comportant entre 4 et 6 uns. Il existe donc suffisamment de mots de 10 bits ayant cette propriété pour coder les 512 mots de 9 bits.

Pour simplifier au mieux les moyens de codage et de décodage, il faut utiliser des règles de codage et de décodage modifiant au minimum les mots de 9 bits ou de 10 bits initiaux.

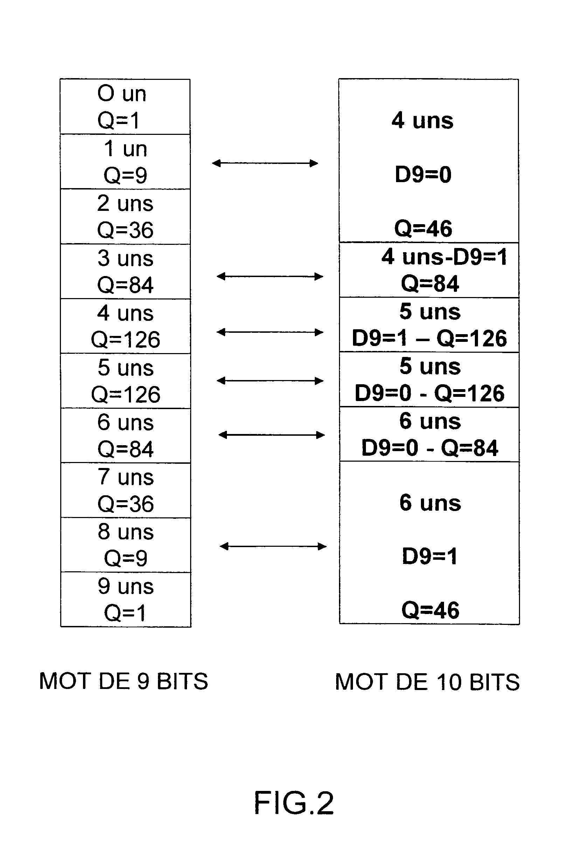

La figure 2 représente un tableau de correspondance entre les 512 mots de 9 bits et 512 mots de 10 bits associés, le premier bit d'un mot de 10 bits étant noté D9. A l'examen du tableau, on constate que :
- Il existe autant de mots de 9 bits comportant 3 uns que de mots de 10 bits comportant 4 uns et débutant par un un ;
- Il existe autant de mots de 9 bits comportant 4 uns que de mots de 10 bits comportant 5 uns et débutant par un un ;
- Il existe autant de mots de 9 bits comportant 5 uns que de mots de 10 bits comportant 5 uns et débutant par un zéro ;
- Il existe autant de mots de 9 bits comportant 6 uns que de mots de 10 bits comportant 6 uns et débutant par un zéro.

A partir de ces remarques, le codage des mots de 9 bits comportant 3, 4, 5 ou 6 uns en mots de 10 bits est simple et obéit aux règles suivantes :
- Le codage d'un mot binaire de 9 bits comportant 3 uns ou 4 uns est obtenu en ajoutant un un audit mot de 9 bits pour obtenir un mot de 10 bits codé ;
- Le codage d'un mot binaire de 9 bits comportant 5 uns ou 6 uns est obtenu en ajoutant un zéro audit mot de 9 bits pour obtenir un mot de 10 bits codé.

Bien entendu, les règles de décodage des mots de 10 bits
- comportant 4 uns et débutant par un un ;
- ou comportant 5 uns ;
- ou comportant 6 uns et débutant par un zéro s'en déduisent immédiatement :
- Le décodage d'un mot binaire de 10 bits comportant 5 uns est obtenu en supprimant le premier bit audit mot de 10 bits pour obtenir un mot de 9 bits décodé ;
- Le décodage d'un mot binaire de 10 bits comportant 4 uns et dont le premier bit est un un est obtenu en supprimant le premier bit audit mot de 10 bits pour obtenir un mot de 9 bits décodé ;
- Le décodage d'un mot binaire de 10 bits comportant 6 uns et dont le premier bit est un zéro est obtenu en supprimant le premier bit audit mot de 10 bits pour obtenir un mot de 9 bits décodé.

Ces règles simples permettent de coder 420 mots de 9 bits.

Il reste à coder 92 mots de 9 bits comportant soit moins de 3 uns soit plus de 6 uns.

A titre d'exemple, les règles de codage et de décodage selon l'invention sont détaillées ci-dessous :
- le codage d'un mot binaire de 9 bits comportant 2 uns est un mot binaire de 10 bits comportant 4 uns, débutant par un zéro, les 9 bits restant étant élaborés à partir du mot de 9 bits d'origine, en remplaçant 2 zéros conjoints dudit mot par deux uns de telle sorte que les 36 mots possibles de 9 bits comportant 2 uns aient tous un codage différencié.
- le codage d'un mot binaire de 9 bits comportant un un est un mot binaire de 10 bits comportant 4 uns, débutant par un zéro et comportant une séquence de 4 bits constituée de quatre uns successifs, la dite séquence pouvant être en deux parties, une première partie située à la fin du mot de 10 bits et la seconde partie située au début du mot de 10 bits après le premier zéro.
- le codage d'un mot binaire de 9 bits comportant 2 zéros ou 7 uns est un mot binaire de 10 bits comportant 4 zéros, débutant par un un ajouté, les 9 bits restant étant élaborés à partir du mot de 9 bits d'origine, en remplaçant 2 uns conjoints par des zéros de telle sorte que les 36 mots possibles aient tous un codage différencié.
- le codage d'un mot binaire de 9 bits comportant un zéro ou 8 uns est un mot binaire de 10 bits comportant 4 zéros, débutant par un un ajouté et comportant une séquence de 4 bits constituée de quatre zéros successifs, la dite séquence pouvant être en deux parties, une première partie située à la fin du mot de 10 bits et la seconde partie située au début du mot de 10 bits après le premier un ajouté de telle sorte que les 9 mots possibles de 9 bits comportant un zéro aient tous un codage différencié.
- Le décodage d'un mot binaire de 10 bits comportant 4 uns et dont le premier bit est un zéro est obtenu en supprimant le premier bit et en changeant au moins deux uns en zéros pour obtenir un mot de 9 bits comprenant au plus 2 uns.
- Le décodage d'un mot binaire de 10 bits comportant 6 uns et dont le premier bit est un un est obtenu en supprimant le premier bit et en changeant au moins deux zéros en uns pour obtenir un mot de 9 bits comprenant au moins 7 uns.

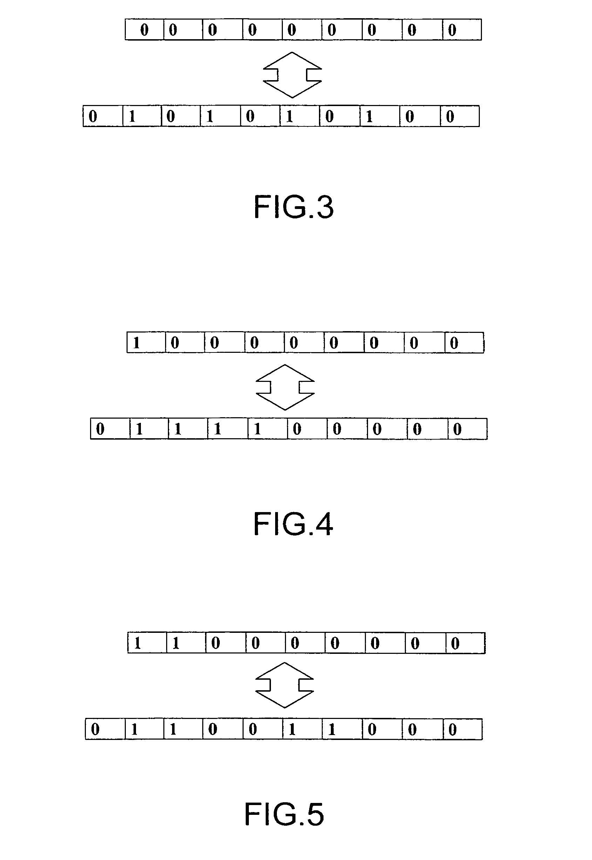

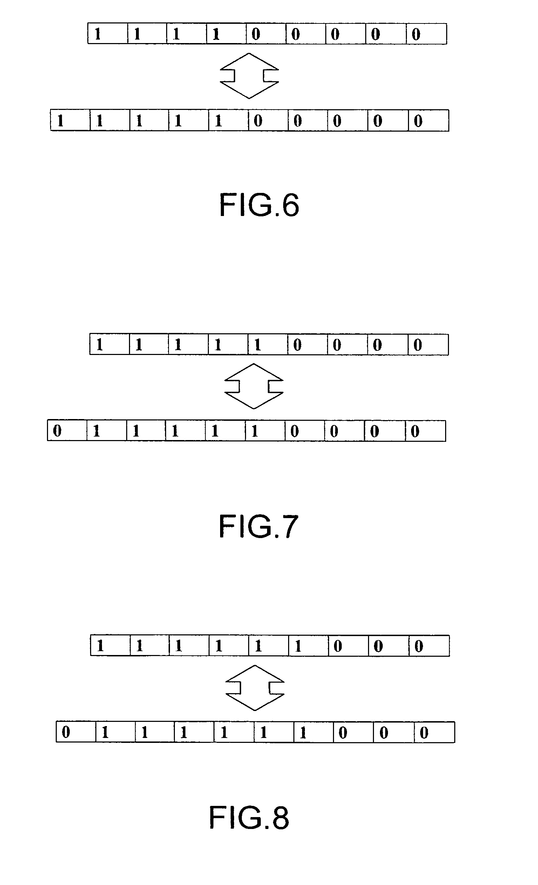

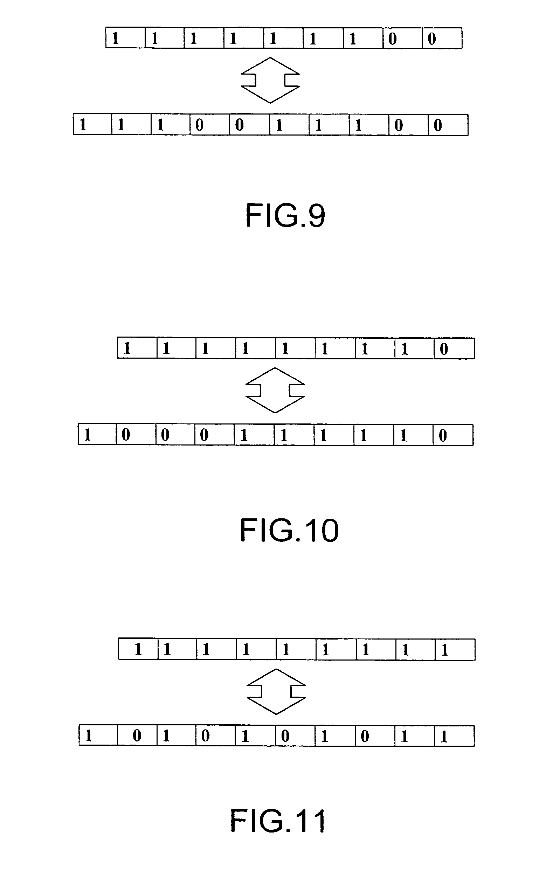

Les figures 3 à 11 représentent pour un mot de 9 bits comportant un nombre croissant de uns variant de 0 à 9 le codage du mot de 10 bits correspondant selon les règles de codage énoncées ci-dessus.

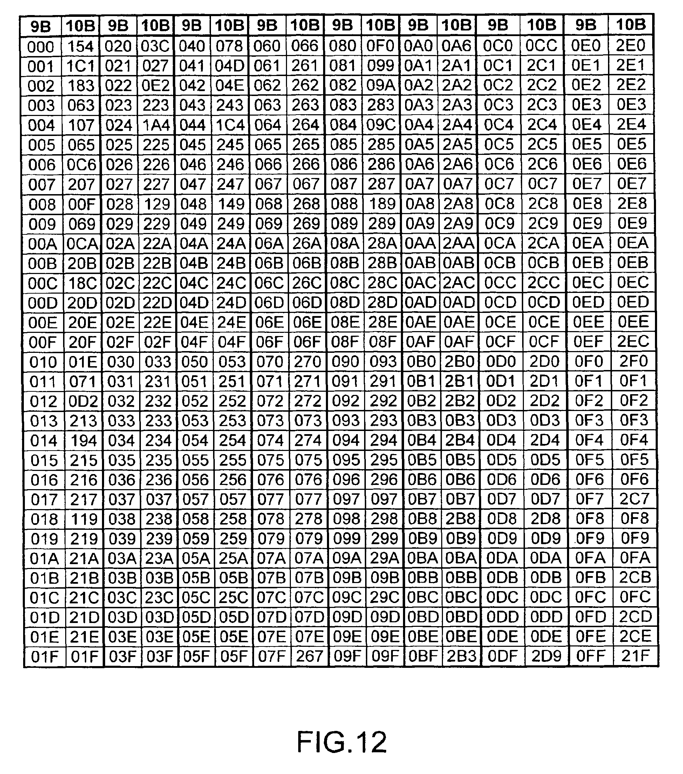

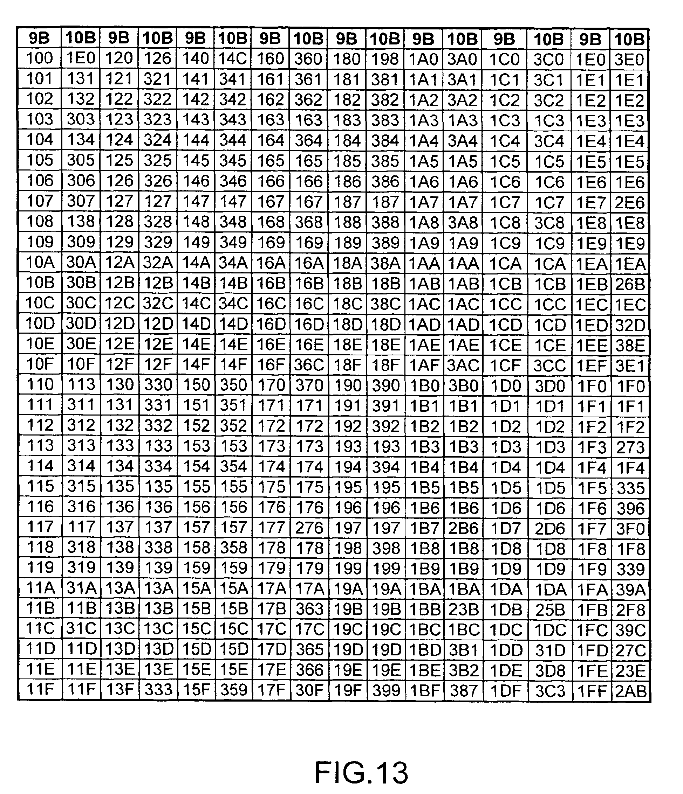

Les figures 12 et 13 représentent deux tableaux comportant 8 paires de colonnes, chaque paire de colonne donnant en hexadécimal le codage et le décodage selon l'invention d'un mot de 9 bits en un mot de 10 bits pour les mots de 9 bits compris entre 000 et 1 FF, soit en décimal, tous les mots de 9 bits compris entre 0 et 511.

Comme on l'a vu, même en ne conservant que les mots de 10 bits comportant de 4 à 6 uns, il reste encore 160 mots de 10 bits comportant ou 4 uns ou 6 uns auxquels ne correspondent aucun mot de 9 bits. Ces mots peuvent être utilisés, par exemple, pour coder des informations de synchronisation ou des mots auxiliaires.

A titre d'exemple non limitatif, le codeur ou le décodeur selon l'invention sont réalisés dans un composant numérique programmable notamment de type FPGA (Fast Programmable Gate Array) ou de type ASIC (Application Specific Integrated Circuit).

Le codage des mots peut être fait soit la forme d'une logique programmée respectant les règles de codage selon l'invention, soit sous la forme d'une table de codage équivalente aux tableaux des figures 12 et 13, soit sous une forme mixte associant logique programmée et table de codage.

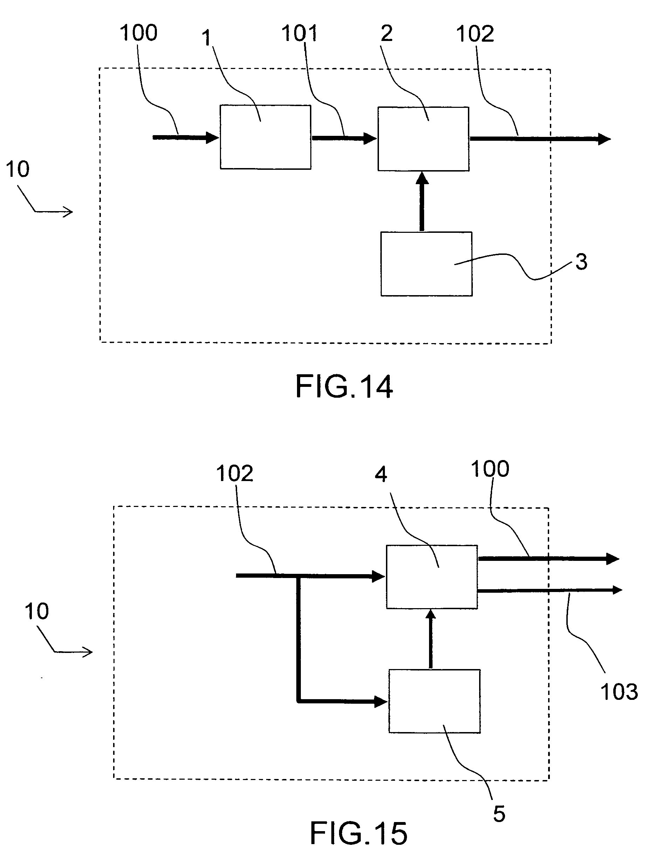

Les figures 14 et 15 illustrent, à titre d'exemple non limitatif, des exemples d'implantation de codeur et de décodeur dans un composant numérique programmable 10 représenté par un rectangle en tracés pointillés sur lesdites figures. Ces dispositifs sont utilisés pour réaliser la transmission de signaux vidéo.

Le dispositif illustré en figure 14 est utilisé pour le codage du signal émis avant transmission par une liaison non représentée sur la figure. Le signal vidéo d'origine 100 représenté par une flèche en tracés gras est composé de mots de 9 bits. Le codeur 1 code lesdits mots en mots de 10 bits selon les modalités de codage de l'invention. Le codeur délivre ainsi un premier signal 101 composé de mots de 10 bits. Des fonctions électroniques spécifiques du composant numérique programmable symbolisées par le rectangle 3 sur la figure 14 génèrent des séquences de synchronisation de type SAV, acronyme anglo-saxon de «Start of Active Video » et de type EAV, acronyme anglo-saxon de «End of Active Video » qui peuvent être identiques ou similaires à celles définies par la norme CCIR-601. De préférence, ces séquences peuvent être composées de mots de 10 bits comportant 4 uns ou 6 uns, mots non utilisés pour assurer le codage des mots de 9 bits. Cependant, il est également possible d'utiliser des mots standards correspondant aux normes vidéo comme les mots hexadécimaux 000 ou 3FF dans la mesure où ces séquences étant de courte durée, elles ne dégradent pas de façon sensible la valeur moyenne des quantités de uns et de zéros transmis. Ces séquences de synchronisation sont insérées à des instants où le signal vidéo ne comporte pas d'information vidéo utile au moyen du multiplexeur 2 qui fournit ainsi un signal 102 comprenant à la fois les mots codés de 10 bits correspondant au signal vidéo 100 et les signaux de synchronisation.

Les circuits d'émission prennent également en compte la contrainte de synchronisation dite byte du désérialisateur du composant de transmission. Cette contrainte consiste à émettre pendant un temps suffisamment long, au moins 1024 fois de suite le mot 01 F correspondant à 5 zéros suivi de 5 uns successifs. Ainsi, la synchronisation peut se faire sans ambiguïté. Cette émission peut être réalisée pendant la phase d'effacement vertical du signal vidéo encore appelée en terminologie anglo-saxonne « vertical back porch » ou « vertical blanking ».

Le dispositif illustré en figure 15 est utilisé pour le décodage du signal reçu après transmission par une liaison non représentée sur la figure. Le signal vidéo d'origine 102 représenté par une flèche en tracés gras est composé de mots de 10 bits. Le signal reçu est envoyé sur le décodeur 4 et sur un décodeur de synchronisation 5 permettant de synchroniser le signal vidéo, cette synchronisation étant symbolisée par une flèche épaisse verticale reliant les éléments 4 et 5. Le décodeur 4 émet deux signaux :
- le signal 100 décodé proprement dit composé de mots de 9 bits symbolisé par une flèche épaisse ;
- un signal d'erreur 103 lorsque le mot de 10 bits encodé ne correspond à aucun mot de 9 bits.

## Revendications

1. Codeur d'un mot binaire de 9 bits en un mot binaire de 10 bits, ledit codeur comportant des moyens de codage, **caractérisé en ce que** lesdits moyens effectuent au moins les codages suivants :
• Le codage d'un mot binaire de 9 bits comportant 3 uns ou 4 uns est obtenu en ajoutant un un audit mot de 9 bits pour obtenir un mot de 10 bits codé ;
• Le codage d'un mot binaire de 9 bits comportant 5 uns ou 6 uns est obtenu en ajoutant un zéro audit mot de 9 bits pour obtenir un mot de 10 bits codé.

2. Codeur selon la revendication 1, **caractérisé en ce que** les moyens de codage effectuent les codages suivants :
• Le codage d'un mot binaire de 9 bits comportant moins de 3 uns est un mot binaire de 10 bits comportant 4 uns et débutant par un zéro.
• Le codage d'un mot binaire de 9 bits comportant plus de 6 uns est un mot binaire de 10 bits comportant 6 uns et débutant par un un.

3. Codeur selon la revendication 2, **caractérisé en ce que** le codage d'un mot binaire de 9 bits comportant 2 uns est un mot binaire de 10 bits comportant 4 uns, débutant par un zéro ajouté, les 9 bits restant étant élaborés à partir du mot de 9 bits d'origine, en remplaçant 2 zéros conjoints par des uns de telle sorte que les 36 mots de 9 bits possibles comportant 2 uns soient tous différenciés.

4. Codeur selon la revendication 2, **caractérisé en ce que** le codage d'un mot binaire de 9 bits comportant un un est un mot binaire de 10 bits comportant 4 uns, débutant par un zéro ajouté et comportant une séquence de 4 bits constituée de quatre uns successifs, la dite séquence pouvant être en deux parties, une première partie située à la fin du mot de 10 bits et la seconde partie située au début du mot de 10 bits après le premier zéro ajouté.

5. Codeur selon la revendication 2, **caractérisé en ce que** le codage d'un mot binaire de 9 bits comportant 2 zéros est un mot binaire de 10 bits comportant 4 zéros, débutant par un un ajouté, les 9 bits étant élaborés à partir du mot de 9 bits d'origine, en remplaçant 2 uns conjoints par des zéros de telle sorte que les 36 mots de 9 bits possibles soient tous différenciés.

6. Codeur selon la revendication 2, **caractérisé en ce que** le codage d'un mot binaire de 9 bits comportant un zéro est un mot binaire de 10 bits comportant 4 zéros, débutant par un un ajouté et comportant une séquence de 4 bits constituée de quatre zéros successifs, la dite séquence pouvant être en deux parties, une première partie située à la fin du mot de 10 bits et la seconde partie située au début du mot de 10 bits après le premier un ajouté.

7. Décodeur d'un mot binaire de 10 bits codé en un mot binaire de 9 bits, ledit décodeur comportant des moyens de décodage, **caractérisé en ce que** lesdits moyens effectuent les décodages uniquement sur les mots de 10 bits comportant ou 4 uns ou 5 uns ou 6 uns et effectuent au moins les décodage suivants :
• Le décodage d'un mot binaire de 10 bits comportant 5 uns est obtenu en supprimant le premier bit audit mot de 10 bits pour obtenir un mot de 9 bits décodé ;
• Le décodage d'un mot binaire de 10 bits comportant 4 uns et dont le premier bit est un un est obtenu en supprimant le premier bit audit mot de 10 bits pour obtenir un mot de 9 bits décodé ;
• Le décodage d'un mot binaire de 10 bits comportant 6 uns et dont le premier bit est un zéro est obtenu en supprimant le premier bit audit mot de 10 bits pour obtenir un mot de 9 bits décodé.

8. Décodeur selon la revendication 7, **caractérisé en ce que** les moyens de décodage effectuent les décodages suivants :
• Le décodage d'un mot binaire de 10 bits comportant 4 uns et dont le premier bit est un zéro est obtenu en supprimant le premier bit et en changeant au moins deux uns en zéros pour obtenir un mot de 9 bits comprenant au plus 2 uns.

9. Décodeur selon la revendication 8, **caractérisé en ce que** les moyens de décodage effectuent les décodages suivants :
• Le décodage d'un mot binaire de 10 bits comportant 6 uns et dont le premier bit est un un est obtenu en supprimant le premier bit et en changeant au moins deux zéros en uns pour obtenir un mot de 9 bits comprenant au moins 7 uns.

10. Composant numérique programmable, notamment de type FPGA (Fast Programmable Gate Array) ou de type ASIC (Application Specific Integrated Circuit) pour applications à l'émission d'un signal vidéo numérique composé de mots de 10 bits à partir d'un signal vidéo numérique composé de mots de 9 bits, **caractérisé en ce qu'**il comporte, au moins, un codeur selon les revendications 1 à 6.

11. Composant numérique programmable, notamment de type FPGA (Fast Programmable Gate Array) ou de type ASIC (Application Specific Integrated Circuit) pour applications à la réception d'un signal vidéo numérique composé de mots de 10 bits pour obtenir un signal vidéo numérique composé de mots de 9 bits, **caractérisé en ce qu'**il comporte, au moins, un décodeur selon les revendications 7 à 9.

## Claims

1. Encoder of a 9-bit binary word into a 10-bit binary word, said encoder comprising encoding means, **characterized in that** said means perform at least the following encoding operations:
• The encoding of a 9-bit binary word comprising three ones or four ones is obtained by adding a one to said 9-bit word to obtain an encoded 10-bit word;
• The encoding of a 9-bit binary word comprising five ones or six ones is obtained by adding a zero to said 9-bit word to obtain an encoded 10-bit word.

2. Encoder according to Claim 1, **characterized in that** the encoding means perform the following encoding operations:
• The encoding of a 9-bit binary word comprising fewer than three ones is a 10-bit binary word comprising four ones and beginning with a zero.
• The encoding of a 9-bit binary word comprising more than six ones is a 10-bit binary word comprising six ones and beginning with a one.

3. Encoder according to Claim 2, **characterized in that** the encoded form of a 9-bit binary word comprising two ones is a 10-bit binary word comprising four ones, beginning with an added zero, the nine remaining bits being generated from the original 9-bit word, by replacing two adjacent zeroes with ones such that the 36 possible 9-bit words comprising two ones are all differentiated.

4. Encoder according to Claim 2, **characterized in that** the encoded form of a 9-bit binary word comprising a one is a 10-bit binary word comprising four ones, beginning with an added zero and comprising a sequence of 4 bits made up of four successive ones, said sequence possibly being in two parts, a first part located at the end of the 10-bit word and the second part located at the start of the 10-bit word after the first added zero.

5. Encoder according to Claim 2, **characterized in that** the encoded form of a 9-bit binary word comprising two zeroes is a 10-bit binary word comprising four zeroes, beginning with an added one, the 9 bits being generated from the original 9-bit word, by replacing two adjacent ones with zeroes such that the 36 possible 9-bit words are all differentiated.

6. Encoder according to Claim 2, **characterized in that** the encoded form of a 9-bit binary word comprising a zero is a 10-bit binary word comprising four zeroes, beginning with an added one and comprising a sequence of 4 bits made up of four successive zeroes, said sequence possibly being in two parts, a first part located at the end of the 10-bit word and the second part located at the start of the 10-bit word after the first added one.

7. Decoder of a 10-bit binary word encoded into a 9-bit binary word, said decoder comprising decoding means, **characterized in that** said means perform decoding operations only on 10-bit words comprising four ones or five ones or six ones and perform at least the following decoding operations:
• The decoding of a 10-bit binary word comprising five ones is obtained by deleting the first bit from said 10-bit word to obtain a decoded 9-bit word;
• The decoding of a 10-bit binary word comprising four ones and the first bit of which is a one is obtained by deleting the first bit from said 10-bit word to obtain a decoded 9-bit word;
• The decoding of a 10-bit binary word comprising six ones and the first bit of which is a zero is obtained by deleting the first bit from said 10-bit word to obtain a decoded 9-bit word.

8. Decoder according to Claim 7, **characterized in that** the decoding means perform the following decoding operations:
• The decoding of a 10-bit binary word comprising four ones and the first bit of which is a zero is obtained by deleting the first bit and by changing at least two ones into zeroes to obtain a 9-bit word comprising no more than two ones.

9. Decoder according to Claim 8, **characterized in that** the decoding means perform the following decoding operations:
• The decoding of a 10-bit binary word comprising six ones and the first bit of which is a one is obtained by deleting the first bit and by changing at least two zeroes into ones to obtain a 9-bit word comprising at least seven ones.

10. Programmable digital component, in particular of the FPGA (Fast Programmable Gate Array) type or of the ASIC (Application-Specific Integrated Circuit) type for applications with the transmission of a digital video signal consisting of 10-bit words from a digital video signal consisting of 9-bit words, **characterized in that** it comprises, at least, an encoder according to Claims 1 to 6.

11. Programmable digital component, in particular of the FPGA (Fast Programmable Gate Array) type or of the ASIC (Application-Specific Integrated Circuit) type for applications with the reception of a digital video signal consisting of 10-bit words to obtain a digital video signal consisting of 9-bit words, **characterized in that** it comprises, at least, a decoder according to Claims 7 to 9.

## Patentansprüche

1. Kodierer eines 9 Bit-Binärworts in ein 10 Bit-Binärwort,
wobei der Kodierer Kodierungsmittel aufweist, **dadurch gekennzeichnet, dass** die Mittel mindestens folgende Kodierungen durchführen:
• Die Kodierung eines 9 Bit-Binärworts, das 3 Einsen oder 4 Einsen aufweist, wird erreicht, indem dem 9 Bit-Wort eine Eins hinzugefügt wird, um ein kodiertes 10 Bit-Wort zu erhalten;
• Die Kodierung eines 9 Bit-Binärworts, das 5 Einsen oder 6 Einsen aufweist, wird erreicht, indem dem 9 Bit-Wort eine Null hinzugefügt wird, um ein kodiertes 10 Bit-Wort zu erhalten.

2. Kodierer nach Anspruch 1, **dadurch gekennzeichnet, dass** die Kodierungsmittel folgende Kodierungen durchführen:
• Die Kodierung eines 9 Bit-Binärworts, das weniger als 3 Einsen aufweist, ist ein 10 Bit-Binärwort, das 4 Einsen aufweist und mit einer Null beginnt.
• Die Kodierung eines 9-Bit-Binärworts, das mehr als 6 Einsen aufweist, ist ein 10 Bit-Binärwort, das 6 Einsen aufweist und mit einer Null beginnt.

3. Kodierer nach Anspruch 2, **dadurch gekennzeichnet, dass** die Kodierung eines 9 Bit-Binärworts, das 2 Einsen aufweist, ein 10 Bit-Binärwort ist, das 4 Einsen aufweist, das mit einer hinzugefügten Null beginnt, wobei die restlichen 9 Bit aus dem ursprünglichen 9-Bit-Wort erstellt werden, indem 2 verbundene Nullen durch Einsen ersetzt werden, so dass die 36 möglichen 9 Bit-Wörter, die 2 Einsen aufweisen, alle unterschiedlich sind.

4. Kodierer nach Anspruch 2, **dadurch gekennzeichnet, dass** die Kodierung eines 9 Bit-Binärworts, das eine Eins aufweist, ein 10 Bit-Binärwort ist, das 4 Einsen aufweist, das mit einer hinzugefügten Null beginnt und eine Folge von 4 Bit aufweist, die aus vier aufeinanderfolgenden Einsen besteht, wobei die Folge aus zwei Teilen bestehen kann, einem ersten Teil, der sich am Ende des 10 Bit-Wortes befindet, und dem zweiten Teil, der sich am Beginn des 10 Bit-Wortes nach der ersten hinzugefügten Null befindet.

5. Kodierer nach Anspruch 2, **dadurch gekennzeichnet, dass** die Kodierung eines 9 Bit-Binärworts, das 2 Nullen aufweist, ein 10 Bit-Binärwort ist, das 4 Nullen aufweist, das mit einer hinzugefügten Eins beginnt, wobei die 9 Bit aus dem ursprünglichen 9 Bit-Wort erstellt werden, indem 2 verbundene Einsen durch Nullen ersetzt werden, so dass die 36 möglichen 9 Bit-Wörter alle unterschiedlich sind.

6. Kodierer nach Anspruch 2, **dadurch gekennzeichnet, dass** die Kodierung eines 9 Bit-Binärworts, das eine Null aufweist, ein 10 Bit-Binärwort ist, das 4 Nullen aufweist, das mit einer hinzugefügten Eins beginnt und eine Folge von 4 Bit aufweist, die aus vier aufeinanderfolgenden Nullen besteht, wobei die Folge aus zwei Teilen bestehen kann, einem ersten Teil, der sich am Ende des 10 Bit-Wortes befindet, und dem zweiten Teil, der sich am Beginn des 10 Bit-Wortes nach der ersten hinzugefügten Eins befindet.

7. Dekodierer eines 10 Bit-Binärworts, das in ein 9-Bit-Binärwort kodiert ist, wobei der Dekodierer Dekodierungsmittel aufweist, **dadurch gekennzeichnet, dass** die Mittel die Dekodierungen nur bei 10 Bit-Wörtern durchführen, die 4 Einsen oder 5 Einsen oder 6 Einsen aufweisen und mindestens folgende Dekodierungen durchführen:
• Die Dekodierung eines 10 Bit-Binärworts, das 5 Einsen aufweist, wird erreicht, indem bei dem 10 Bit-Wort das erste Bit unterdrückt wird, um ein dekodiertes 9 Bit-Wort zu erhalten;
• Die Dekodierung eines 10 Bit-Binärworts, das 4 Einsen aufweist und dessen erstes Bit eine Eins ist, wird erreicht, indem bei dem 10 Bit-Wort das erste Bit unterdrückt wird, um ein dekodiertes 9 Bit-Wort zu erhalten;
• Die Dekodierung eines 10 Bit-Binärworts, das 6 Einsen aufweist und dessen erstes Bit eine Null ist, wird erreicht, indem bei dem 10 Bit-Wort das erste Bit unterdrückt wird, um ein dekodiertes 9 Bit-Wort zu erhalten.

8. Dekodierer nach Anspruch 7, **dadurch gekennzeichnet, dass** die Dekodierungsmittel folgende Dekodierungen durchführen:
• Die Dekodierung eines 10 Bit-Binärworts, das 4 Einsen aufweist und dessen erstes Bit eine Null ist, wird erreicht, indem das erste Bit unterdrückt wird und indem mindestens zwei Einsen in Nullen verwandelt werden, um ein 9 Bit-Wort zu erhalten, das höchstens 2 Einsen aufweist.

9. Dekodierer nach Anspruch 8, **dadurch gekennzeichnet, dass** die Dekodierungsmittel folgende Dekodierungen durchführen:
• Die Dekodierung eines 10 Bit-Binärworts, das 6 Einsen aufweist und dessen erstes Bit eine Eins ist, wird erreicht, indem das erste Bit unterdrückt wird und indem mindestens zwei Nullen in Einsen verwandelt werden, um ein 9 Bit-Wort zu erhalten, das mindestens 7 Einsen aufweist.

10. Programmierbares numerisches Bauteil, insbesondere vom Typ FPGA (Fast Programmable Gate Array) oder vom Typ ASIC (Application Specific Integrated Circuit), für Anwendungen bei der Aussendung eines numerischen Videosignals, das aus 10 Bit-Wörtern besteht, aus einem numerischen Videosignal, das aus 9 Bit-Wörtern besteht, **dadurch gekennzeichnet, dass** es mindestens einen Kodierer nach Anspruch 1 bis 6 aufweist.

11. Programmierbares numerisches Bauteil, insbesondere vom Typ FPGA (Fast Programmable Gate Array) oder vom Typ ASIC (Application Specific Integrated Circuit), für Anwendungen bei dem Empfang eines numerischen Videosignals, das aus 10 Bit-Wörtern besteht, um ein numerisches Videosignal zu erhalten, das aus 9 Bit-Wörtern besteht, **dadurch gekennzeichnet, dass** es mindestens einen Dekodierer nach Anspruch 7 bis 9 aufweist.
